# EUROPEAN PATENT SPECIFICATION

(11) **EP 0 415 692 B1**
(45) Date of publication and mention of the grant of the patent: **03.05.1995**
(21) Application number: 90309366.4
(22) Date of filing: 28.08.1990
(51) Int. Cl.: F16B 11/00, C09J 7/02

(54) **Bonding of articles**
Verbinden der Gegenstände
Liaison d'articles

(30) Priority: 26.08.1989 GB 8919459
(43) Date of publication of application: 06.03.1991
(73) Proprietor: CLYDE PRODUCT TECHNOLOGY LIMITED, Bridge of Weir, Renfrewshire PA11 3SA (GB)
(72) Inventor: Hamilton, Sheila, Renfrewshire PA16 8DN, Scotland (GB)
(74) Representative: Pacitti, Pierpaolo A.M.E.

(56) References cited:
- FR-A- 2 139 997
- FR-A- 2 507 196
- NL-A- 7 713 911

## Description

This invention relates to methods and materials for bonding of articles, particularly but not exclusively the bonding of components onto a component carrier such as, for example, heatsinks onto PCB's (printed circuit boards).

With regard to method for the bonding of heatsinks onto PCB's, two methods are currently used, the 'prepreg' method and the 'adhesive film' method.

Prepreg consists of a glass cloth impregnated with a partially cured resin to form a thin sheet which is machined to the same shape as the heatsink. The machined prepreg is placed between the heatsink and the PCB, and heat and pressure are applied to melt and cure the thermosetting resin, so bonding the heatsink to the PCB. However, the bonding takes place at around 175 degrees Celsius, and because of the difference between the coefficients of thermal expansion of the heatsink and the PCB, the bonded assembly bows on cooling to room temperature. This makes assembly difficult.

Adhesive films are sometimes used for cold bonding of simple shaped parts (see for example FR-A-2 507 196), but the difficulty and expense of cutting the adhesive film to match complex shapes have limited the use of the adhesive film method of bonding.

It is therefore an object of the invention to provide an improved method of and material for bonding of articles.

According to the present invention there is provided a method of bonding a first article to a second article, said method comprising the steps of providing a carrier sheet detachably carrying a plurality of closely spaced discrete nodules of adhesive, applying a contoured surface portion of the first article to said carrier sheet to cause said surface portion of the first article to become substantially covered with nodules of adhesive adhered thereto, removing said first article from said carrier sheet along with the nodules of adhesive transferred to said first article and thereby detaching these nodules from said carrier sheet, and applying the adhesive-covered contoured surface portion of the first article to a surface portion of the second article to cause the adhesive therebetween to bond the first article to the second article; characterised in that the quantity of adhesive in each nodule in relation to the separation between adjacent nodules is preferably such that in the final inter-article bond, the inter-nodule separations are substantially eliminated by lateral flow of adhesive.

Preferably, said surface portions of the first and second articles are each substantially planar.

Said first article may be an electronic component, such as a heatsink, and said second article a component, such as a printed circuit board on which said component is to be mounted.

Said method preferably further includes a preliminary step of rendering at least said surface portions of the first and second articles clean and dry, to be substantially free of moisture, dust, and hydrocarbons.

Preferably the adhesive is uncured or incompletely cured pressure sensitive adhesive, and the first and second articles are pressurised towards one another to cause the pressure sensitive adhesive to bond the articles together.

The adhesive preferably cures at ambient temperature. The adhesive may comprise a cross-linked acrylic material.

The carrier sheet may be constituted by a release paper.

Embodiments of the present invention will now be described by way of example with reference to the accompanying drawings in which:-
Fig. 1 is a perspective view of a material for bonding a first article to a second article made in accordance with the present invention;
Fig. 2 is a cross section view of the material of Fig. 1 taken in the direction of arrows II - II of Fig. 1; and
Figs 3a, 3b and 3c illustrate the method of bonding a first article to a second article in accordance with the present invention.

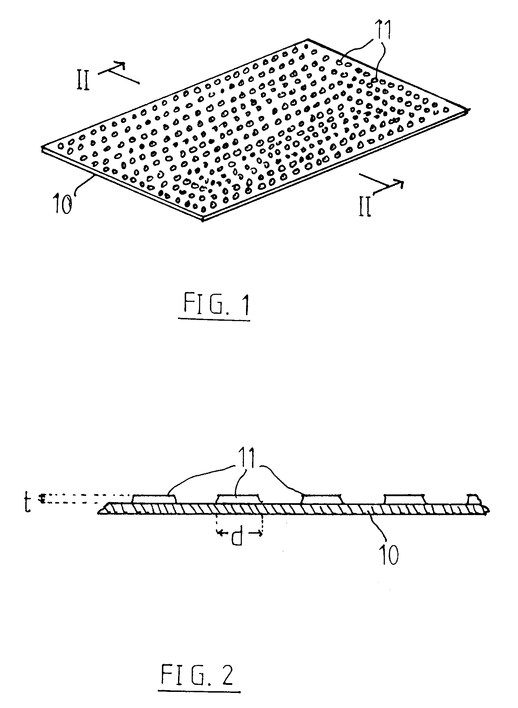

Referring to Figs 1 and 2 of the accompanying drawings a material for bonding a first article to a second article comprises a carrier sheet 10 in the form of a release paper on one surface on which there are applied a plurality of closely spaced discrete nodules 11 of adhesive. The nodules may be of any shape but are preferably in the form of a regular array of closely packed separate dots.

It is preferable that the quantity of adhesive in each nodule in relation to the separation between adjacent nodules is such that in the final inter-article bond, the inter-nodule separations are substantially eliminated by lateral flow of the adhesive. A usable range of coverage of nodules 11 of the carrier sheet 10 is 30% - 90% coverage, the preferable range being between 67% - 90% and in one specific example a coverage of 77% has been found to be appropriate.

With reference to Fig. 2 it has been found that a dot diameter d of between 0.5mm - 2.5mm and more specifically between 0.7mm and 1.5mm is suitable and in one specific example a dot diameter of 1.1mm was used.

The dots are applied to give a coating thickness t of between 50 to 150 microns, a range of 80 to 150 microns being preferable and more specifically a thickness of 100 microns is used.

A number of adhesive formulations are applicable such as acrylic, epoxy, silicone or polyurethane polymer dispersed in water or solvent. Acrylic-based pressure sensitive adhesives are preferred.

In order to allow the bonding method to be used in applications where heat is applied to the articles after bonding such as, for example, when a component is bonded to a printed circuit board and wave soldering is thereafter effected, it is necessary that the adhesive composition exhibits a degree of temperature resistance. Whilst a range of between 20°C to 260°C can be used, it is preferred that the adhesive exhibits temperature resistance of at least 80°C, and in one specific example at least 100°C. In exhibiting this temperature resistance the bonding method of the invention can be applied in a number of situations hitherto not proposed.

To permit the method of the invention to be used in bonding components to component carriers, the adhesive requires to exhibit also a high degree of static shear strength and a high degree of peel strength. With regard to static strength, a range of 5 - 150 hours at 100°C at 250g is applicable but a preferable range is 50 - 110 hours and more specifically 100 hours. With regard to peel strength, a range of 5 - 20 N/25mm is usable with a range of 10 - 20 N/25mm being preferable, with a specific example being 11 N/25mm.

When the invention is applied to the bonding of electrical components to PCB's it is preferred that the adhesive exhibits good thermal and electrical conductivity. A thermal conductivity of between 50 and 450W/m°C is applicable but a preferable range is between 140 and 450W/m°C and more specifically 360W/m°C may be used. Further, in certain applications it is preferred that the adhesive exhibits electrical conductivity of between 0.01 - 0.5Ω/square unit. In other applications the adhesive should be capable of withstanding a breakdown voltage of between 50 and 600V.

The bonding method of the invention can also be applied to the bonding of electronic components to printed circuit boards whilst permitting electrical connection to be established. In such cases an anisotropic adhesive is used. This permits all the advantages of the bonding method as described above whilst eliminating the need to effect electrical connection. By way of example a coating thickness t of between 10 and 25 microns would be appropriate, the anisotropic material having a conductivity of between 0.02 - 0.07Ω/square unit.

The dots 11 may be applied to the carrier sheet 10 by any suitable method. It has been found that to give the necessary coating thickness and dot definition coating using a stencil is appropriate. However, application of the dots by a gravure process may also be used.

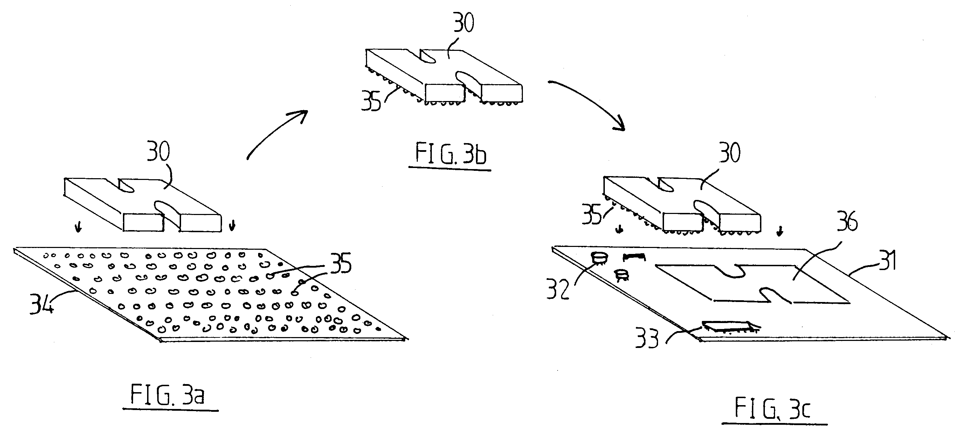

There will now be described, with reference to Figs 3a - 3c, one embodiment of the method of the invention.

An irregularly-outlined electrical component, for example, a heatsink 30 is to be bonded to a PCB 31 including a circuit to which other electronic components 32,33 are connected. Bonding is completed without application of heat. The following procedure is adopted:-
Both the flat underside of the heatsink 30, and the area 36 of the PCB 31 onto which the heatsink 30 is to be bonded are thoroughly cleaned and dried, to be free of moisture, dust, oil and grease. A release paper 34 coated with a regular array of close-packed but individually separate dots or nodules 35 of pressure-sensitive acrylic adhesive is placed on a work-surface with the adhesive uppermost. As shown in Fig. 3a, the heatsink 30 is placed on the paper 34, with its flat underside fully over the array of adhesive dots 35, and momentarily pressed downwards. This pressure caused the dots 35 of adhesive to adhere to the entire area of the flat underside of the heatsink 30, which is then lifted off the release paper as shown in Fig. 3b. The adhesive 35 clinging to the underside of the heatsink 30 lifts off the release paper with the heatsink. However, because of the complete separation of each dot 35 from its neighbours, those dots attached to the heatsink 30 are lifted cleanly off the release paper 34 without disturbing those dots not imposed upon by the heatsink 30, even where they are immediately adjacent to the edge of the heatsink. Thus the mutual separation of individual adhesive nodules enables automatic 'outlining' of the area of adhesive applied to the heatsink, regardless of the complexity of outline. Conformity of adhesive coat to the outline of the heatsink is improved by having the plan area of individual nodules very small relative to the heatsink contact area, and by having minimal inter-nodular separation as described earlier.

Next, as shown in Fig. 3c, the adhesive-coated heatsink 30 is lowered onto the PCB 31 in the intended final location 36 of the heatsink, and pressed against the PCB. This pressure activates the pressure-sensitive adhesive, which then cold-bonds the heatsink onto the PCB.

Bonding is improved by arranging that the volume of adhesive in each nodule was high enough, and the inter-nodular separation low enough, that upon the final installation of the heatsink on the PCB and the application of pressure at that time, the adhesive in the nodules flows laterally to fill the inter-nodular gaps and produces a layer of adhesive between the heatsink and the PCB which is substantially void-free and of adequate thickness.

Components and articles other than heatsinks may be bonded to PCB's by this method, or to articles other than PCB's.

The invention is considered to have particular application in circumstances where mechanically strong bonding of articles is required by a non-fluent adhesive, but without the use of heat (eliminating thermally cured prepreg), especially in respect of articles whose mutual contact area has an awkward or irregular outline which would make it difficult and/or uneconomic to provide accurately profiled adhesive films (which also require precise manipulation to obviate mis-registration).

While certain modifications and variations have been described above, the invention not restricted thereto, and other modifications and variations can be adopted without departing from the scope of the invention.

## Claims

1. A method of bonding a first article (30) to a second article (31), said method comprising the steps of providing a carrier sheet (34) detachably carrying a plurality of closely spaced discrete nodules (35) of adhesive, applying a contoured surface portion of the first article (30) to said carrier sheet (34) to cause said surface portion of the first article (30) to become substantially covered with nodules (35) of adhesive adhered thereto, removing said first article (30) from said carrier sheet (34) along with the nodules (35) of adhesive transferred to said first article (30) and thereby detaching these nodules (35) from said carrier sheet (34) and applying the adhesive-covered contoured surface portion of the first article (30) to a surface portion of the second article (31) to cause the adhesive therebetween to bond the first article (30) to the second article (31); characterised in that the quantity of adhesive in each nodule (35) in relation to the separation between adjacent nodules (35) is such that in the final inter-article bond the inter-nodule separations are substantially eliminated by lateral flow of adhesive.

2. A method as claimed in Claim 1, wherein the first article (30) is an electrical component and the second article (31) is a component carrier.

3. A method as claimed in Claim 2, wherein the component (30) is a heatsink and the component carrier (31) is a printed circuit board.

4. A method as claimed in any preceding Claim, wherein the nodules (35) of adhesive are applied to the carrier sheet (34) such as to provide coverage in the range of 30% - 90%.

5. A method as claimed in Claim 4, wherein the range is 67% - 90%.

6. A method as claimed in any preceding Claim, wherein the nodules (35) are in the form of dots of diameter (d) of between 0.5mm and 2.5mm.

7. A method as claimed in Claim 6, wherein the dot diameter (d) is between 0.7mm and 1.5mm.

8. A method as claimed in any preceding Claim, wherein the adhesive is applied as a coating having a thickness (t) of between 50 and 150 microns.

9. A method as claimed in Claim 8, wherein the thickness (t) is between 80 and 150 microns.

10. A method as claimed in any preceding Claim, wherein the adhesive is a pressure sensitive acrylic adhesive.

11. A method as claimed in any preceding Claim, wherein the adhesive exhibits a temperature resistance of between 20 and 260°C.

12. A method as claimed in Claim 11, wherein the adhesive exhibits a temperature resistance of at least 80°C.

13. A method as claimed in Claim 12, wherein the adhesive exhibits a shear strength of between 5 and 150 hours at 100°C at 250g.

14. A method as claimed in any preceding Claim, wherein the adhesive exhibits a peel strength of between 5 and 20 N/25mm.

15. A method as claimed in any preceding Claim, wherein the adhesive exhibits a thermal conductivity of between 50 and 450° W/m°C.

16. A method as claimed in any preceding Claim, wherein the adhesive is an anisotropic adhesive.

## Patentansprüche

1. Verfahren zum Verbinden eines ersten Gegenstandes (30) mit einem zweiten Gegenstand (31), Wobei das verfahren besteht aus den Stufen der Bereitstellung eines Trägersheets bzw. einer Trägerbahn (34), das oder die eine Vielzahl eng beabstandeter einzelner Knöllchen (35) eines Bindemittels lösbar trägt, der Anbringung eines profilierten Oberflächenbereichs des ersten Gegenstandes (30) auf dem Trägersheet (34), sodaß der Oberflächenbereich des ersten Gegenstandes (30) mit den damit verbundenen Knöllchen (35) des Bindemittels im wesentlichen bedeckt wird, einem Entfernen des ersten Gegenstandes (30) von dem Trägersheet (34) zusammen mit den auf den ersten Gegenstand (30) übertragenen Knöllchen (35) des Bindemittels und dadurch einem Ablösen dieser Knöllchen (35) von dem Trägersheet (34) und einem Anbringen des mit dem Bindemittel bedeckten, profilierten Oberflächenbereichs des ersten Gegenstandes (30) an einem Oberflächenbereich des zweiten Gegenstandes (31), damit das Bindemittel zwischen beiden den ersten Gegenstand (30) mit dem zweiten Gegenstand (31) verbindet; dadurch gekennzeichnet, daß die Menge des Bindemittels bei jedem Knöllchen (35) in bezug auf den Abstand zwischen benachbarten Knöllchen (35) so ist, daß bei der fertigen Verbindung zwischen den Gegenständen die Abstände zwischen den Knöllchen durch ein seitliches Fließen des Bindemittels im wesentlichen eliminiert sind.

2. Verfahren nach Anspruch 1, bei welchem der erste Gegenstand (30) eine elektrische Komponente und der zweite Gegenstand (31) ein Komponententräger ist.

3. Verfahren nach Anspruch 2, bei welchem die Komponente (30) ein Kühl- bzw. Abstrahlblech und der Komponententräger (31) eine bedruckte Schalttafel ist.

4. Verfahren nach einem der vorhergehenden Ansprüche, bei welchem die Knöllchen (35) des Bindemittels auf das Trägersheet (34) derart aufgebracht werden, daß eine Abdeckung in dem Bereich von 30 % - 90 % bereitgestellt wird.

5. Verfahren nach Anspruch 4, bei welchem der Bereich 67 % - 90 % beträgt.

6. Verfahren nach einem der vorhergehenden Ansprüche, bei welchem die Knöllchen (35) als Tupfen mit einem Durchmesser (d) zwischen 0.5 mm und 2.5 mm ausgebildet sind.

7. Verfahren nach Anspruch 6, bei welchem der Tupfendurchmesser (d) zwischen 0.7 mm und 1.5 mm beträgt.

8. Verfahren nach einem der vorhergehenden Ansprüche, bei welchem das Bindemittel als eine Beschichtung mit einer Dicke (t) zwischen 50 und 150 Mikrons aufgetragen wird.

9. Verfahren nach Anspruch 8, bei welchem die Dicke (t) zwischen 80 und 150 Mikrons beträgt.

10. Verfahren nach einem der vorhergehenden Ansprüche, bei welchem das Bindemittel ein drucksensitives Acrylbindemittel ist.

11. Verfahren nach einem der vorhergehenden Ansprüche, bei welchem das Bindemittel einen Temperaturwiderstand zwischen 20 und 260°C ergibt.

12. Verfahren nach Anspruch 11, bei welchem das Bindemittel einen Temperaturwiderstand von wenigstens 80°C ergibt.

13. Verfahren nach Anspruch 12, bei welchem das Bindemittel eine Scherfestigkeit zwischen 5 und 150 Stunden bei 100°C und bei 250 g ergibt.

14. Verfahren nach einem der vorhergehenden Ansprüche, bei welchem das Bindemittel eine Abschälfestigkeit zwischen 5 und 20 N/25 mm ergibt.

15. Verfahren nach einem der vorhergehenden Ansprüche, bei welchem das Bindemittel eine Wärmeleitfähigkeit zwischen 50 und 450 W/m°C ergibt.

16. Verfahren nach einem der vorhergehenden Ansprüche, bei welchem das Bindemittel ein anisotropisches Bindemittel ist.

## Revendications

1. Procédé de fixation d'un premier article (30) à un second article (31), ledit procédé comprenant les étapes consistant à fournir une feuille de support (34) portant de façon détachable une pluralité de nodules (35) d'adhésif séparés mais rapprochés, à appliquer une partie de surface dudit premier articule (30) ayant un contour à ladite feuille de support (34) de façon à faire que ladite partie de surface du premier article (30) devienne sensiblement couverte des nodules (35) d'adhésif qui y ont adhéré, à enlever ledit premier article (30) de ladite feuille de support (34) en même temps que les nodules (35) d'adhésif transférés vers ledit premier article et de cette façon à détacher lesdits nodules (35) de ladite feuille de support (34) et appliquer la partie de surface à contour couverte d'adhésif du premier article (30) à une partie de surface du second article (31) afin que l'adhésif qui est entre eux fixe le premier article (30) au second article (31); caractérisé en ce que la quantité d'adhésif de chaque nodule (35) en rapport avec la séparation entre les nodules adjacents (35) est telle que dans la fixation finale entre les articles les séparations inter-nodules sont sensiblement éliminées en raison du fluage latéral de l'adhésif.

2. Procédé selon la revendication 1, dans lequel le premier article (30) est un composant électrique et le second article (31) est un support de composant.

3. Procédé selon la revendication 2, dans lequel le composant (30) est un puits thermique et le support de composant (31) est une carte de circuit imprimé.

4. Procédé selon l'une quelconque des revendications précédentes, dans lequel les nodules (35) d'adhésif sont appliqués à la feuille de support (34) de façon à assurer une couverture dans la plage de 30 à 90%.

5. Procédé selon la revendication 4, dans lequel la plage va de 67 % à 90 %.

6. Procédé selon l'une quelconque des revendications précédentes, dans lequel les nodules (35) sont sous forme de taches d'un diamètre (d) compris entre 0, 5 mm et 2, 5 mm.

7. Procédé selon la revendication 6, dans lequel le diamètre (d) des taches est compris entre 0,7 mm et 1,5 mm.

8. Procédé selon l'une quelconque des revendications précédentes, dans lequel l'adhésif est appliqué en tant que revêtement d'une épaisseur (t) comprise entre 50 et 150 micromètres.

9. Procédé selon l'une la revendication 8, dans lequel l'épaisseur (t) est comprise entre 80 et 150 micromètres.

10. Procédé selon l'une quelconque des revendications précédentes, dans lequel l'adhésif est un adhésif acrylique sensible à la pression.

11. Procédé selon l'une quelconque des revendications précédentes, dans lequel l'adhésif présenté une résistance à la température entre 20 et 260°.

12. Procédé selon la revendication 11, dans lequel l'adhésif présente une résistance à la température d'au moins 80°C.

13. Procédé selon la revendication 12, dans lequel l'adhésif présente une résistance au cisaillement comprise entre 5 et 150 heures à 100°C sous 250 g.

14. Procédé selon l'une quelconque des revendications précédentes, dans lequel l'adhésif présente une résistance au pelage comprise entre 5 et 20 N/25mm.

15. Procédé selon l'une quelconque des revendications précédentes, dans lequel l'adhésif présente une conductivité thermique comprise entre 50 et 450° W/m°C.

16. Procédé selon l'une quelconque des revendications précédentes, dans lequel l'adhésif est un adhésif anisotropique.
